(19) Europäisches Patentamt
European Patent Office
Office européen des brevets

(11) Veröffentlichungsnummer: **0 363 817 A2**

(12) # EUROPÄISCHE PATENTANMELDUNG

(21) Anmeldenummer: **89118468.1**

(51) Int. Cl.$^5$: **G03F 7/038**

(22) Anmeldetag: **05.10.89**

(30) Priorität: **14.10.88 DE 3835039**
**05.12.88 DE 3840910**

(43) Veröffentlichungstag der Anmeldung:
**18.04.90 Patentblatt 90/16**

(84) Benannte Vertragsstaaten:
**CH DE FR GB LI**

(71) Anmelder: **HOECHST AKTIENGESELLSCHAFT**
**Postfach 80 03 20**
**D-6230 Frankfurt am Main 80(DE)**

(72) Erfinder: **Prass, Werner, Dr. Dipl.-Chem.**
**Bahnstrasse 19**
**D-6500 Mainz 1(DE)**
Erfinder: **Zertani, Rudolf, Dr. Dipl.-Chem.**
**Hans-Zöller-Strasse 111**
**D-6500 Mainz-Laubenheim(DE)**
Erfinder: **Lingnau, Jürgen, Dr. Dipl.-Chem.**
**Karolingerstrasse 10**
**D-6500 Mainz 43(DE)**
Erfinder: **Hanold, Norbert, Dr. Dipl.-Chem.**
**Kleine Dresdener Strasse 5**
**D-6204 Taunusstein-Wehen(DE)**
Erfinder: **Meier, Herbert, Prof. Dr., Dipl.-Chem.**
**Burgunderstrasse 18**
**D-6501 Zornheim(DE)**

(54) **Negativ arbeitendes strahlungsempfindliches Gemisch, enthaltend ein Polymeres mit 1,2,3-Thiadiazolgruppen, sowie dieses enthaltendes Aufzeichnungsmaterial.**

(57) Es wurde ein negativ arbeitendes, strahlungsempfindliches Gemisch beschrieben, das aus einem Bindemittel und einem 1,2,3-Thiadiazolgruppen enthaltenden Polymeren besteht.

Als Bindemittel wird eine mehrfunktionelle Verbindung eingesetzt, deren funktionelle Gruppen mit Keten reagieren; als Polymeres wird eine Verbindung verwendet, die durch Polymerisation einer Verbindung der allgemeinen Formel I

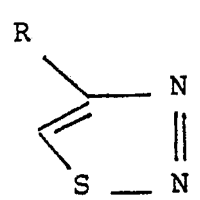

(I)

entsteht, worin R eine polymerisierbare Gruppe bedeutet.

Sofern das Polymere ein Copolymeres darstellt, worin als Comonomeres Verbindungen enthalten sind, die funktionelle Gruppen aufweisen, die mit Keten reagieren können, kann auf das Bindemittel verzichtet werden.

Das beschriebene negativ arbeitende, strahlungsempfindliche Gemisch eignet sich besonders für UV-, Elektronen- und Röntgenstrahllithographie.

EP 0 363 817 A2

Xerox Copy Centre

# Negativ arbeitendes strahlungsempfindliches Gemisch, enthaltend ein Polymeres mit 1,2,3-Thiadiazolgruppen, sowie dieses enthaltendes Aufzeichnungsmaterial

Die Erfindung betrifft ein negativ arbeitendes, strahlungsempfindliches Gemisch, enthaltend ein Bindemittel und ein 1,2,3-Thiadiazolgruppen enthaltendes Polymeres.

Negativ arbeitende, strahlungsempfindliche Gemische sind in der Literatur hinlänglich beschrieben. Trotz verschiedener Ausführungsformen wird bei allen die Löslichkeit des strahlungsempfindlichen Gemisches in einem geeigneten Entwickler durch eine photochemisch ausgelöste Reaktion herabgesetzt.

Das obengenannte Prinzip wird auch in einem Aufzeichnungsmaterial beobachtet, das ungesättigte, polymerisationsfähige Verbindungen in Kombination mit einem Photoinitiator in einem solchen Gemisch enthält. Das Aufzeichnungsmaterial wird mit Licht bzw. Strahlung im Absorptionsbereich des Photoinitiators bildmäßig belichtet, die einsetzende Polymerisationsreaktion gegebenenfalls durch Erhöhung der Temperatur beschleunigt. Anschließend werden die nicht belichteten, d.h. die nicht polymerisierten Bereiche des Aufzeichnungsmaterials, in einem geeigneten Entwickler entfernt. Repräsentativ für ein solches System ist die EP-A 0 053 708.

In einer anderen Variante werden durch die Photoreaktion vernetzungsfähige Zwischenprodukte gebildet, die anschließend mit geeigneten funktionellen Gruppen anderer im strahlungsempfindlichen Gemisch enthaltenen Komponenten, z. B. einem Bindemittel, vernetzen. Strahlungsempfindliche Gemische dieses Typs enthalten als strahlungsempfindliche Komponente z. B. mindestens bifunktionelle Azide. Als Beispiele sollen hier nur die DE-A 15 72 067, 15 72 068, 15 72 069 und 15 72 070 genannt werden.

Weiterhin gibt es Systeme, deren Hydrophilie durch Einstrahlung von Licht geändert wird. Zu solchen Systemen werden Gemische gezählt, die Diazoniumsalze in Kombination mit geeigneten Bindemitteln enthalten. Durch Einstrahlung von Licht wird die Abspaltung von Stickstoff ausgelöst, wodurch aufgrund von Folgereaktionen die Alkalilöslichkeit des strahlungsempfindlichen Gemisches in den bildmäßig belichteten Bereichen drastisch reduziert wird. Solche Systeme werden in den EP-A 0 152 819 und 0 048 876 beschrieben.

Während die zuerst genannten photopolymerisierbaren Systeme Vorteile hinsichtlich der erzielbaren Empfindlichkeit bieten, da bei ihnen ein Verstärkungseffekt durch den Radikalkettenmechanismus auftritt, bieten die beiden zuletzt genannten Systeme Vorteile bei der Auflösung und der Qualität der wiedergegebenen Strukturen. Speziell für die Strukturierung mit hochenergetischer, ionisierender Strahlung (z. B. Elektronen- und Röntgenstrahlung) werden negativ arbeitende, lichtempfindliche Gemische auf der Basis von Polyacrylaten und Polychlormethylstyrolen eingesetzt. Bei diesen Systemen liegt auch ein Verstärkungseffekt vor, obwohl es sich um vernetzende Systeme handelt, da die Quantenausbeute in diesen Fällen für die Vernetzungsreaktionen deutlich über 1 liegt.

Die beschriebenen negativ arbeitenden, strahlungsempfindlichen Systeme sind aber alle hinsichtlich der zu wählenden Strahlung stark eingeschränkt. So weisen sowohl strahlungsempfindliche Gemische, die Komponenten mit Azidgruppen enthalten, als auch solche, die Verbindungen mit Diazoniumgruppen enthalten, Absorptionsmaxima im nahen UV-Bereich auf (~365 nm), da die beschriebenen funktionellen Gruppen direkt an aromatische Systeme gebunden sind. Strahlungsempfindliche Gemische dieser Art erfordern aber als zusätzliche Komponente ein Bindemittel. Polyacrylate und Polychlormethylstyrole weisen dagegen im UV(II)-Bereich nur eine geringe Empfindlichkeit auf. Sie sind daher in ihrer Anwendungsbreite in diesem Bereich sehr stark eingeschränkt.

Aufgabe war es daher, ein strahlungsempfindliches Gemisch bereitzustellen, das sowohl für die Lithographie im UV-Bereich als auch für die Röntgen- und Elektronenstrahllithographie geeignet ist.

Gelöst wird die Aufgabe durch Bereitstellen eines strahlungsempfindlichen Gemisches der eingangs beschriebenen Gattung, welches dadurch gekennzeichnet ist, daß das Bindemittel eine mehrfunktionelle Verbindung darstellt, deren funktionelle Gruppen mit Keten reagieren, und daß das Gemisch als Polymeres eine Verbindung enthält, die durch Polymerisation einer Verbindung der allgemeinen Formel I

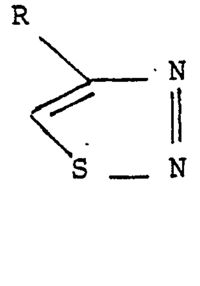

(I)

erhalten wurde, worin R eine polymerisierbare Gruppe bedeutet. Besonders bevorzugt sind Verbindungen, worin R Vinyl, 2-Propenyl oder Butadienyl bedeutet.

Die Verbindungen der allgemeinen Formel I können als Homopolymerisat vorliegen. Es sind aber auch Copolymere mit anderen üblichen, ungesättigte Gruppen enthaltenden Verbindungen möglich. Zu nennen sind hierbei: Styrole, Acrylsäuren, Methacrylsäuren und deren Derivate, insbesondere 2-Hydroxyethylmethacrylat, Maleinsäure, Itaconsäure sowie deren Derivate und Ester, Vinylphenole, Vinylacetate, Vinylalkohole und Vinylacetale. Insbesondere bevorzugt sind solche Comonomere zur Polymerisation mit den Verbindungen der allgemeinen Formel I, die freie Hydroxylgruppen enthalten.

Es sind aber auch Copolymere als Bindemittel einsetzbar, bei denen ein Teil auch aus Monomeren bestehen kann, die keine der beschriebenen funktionellen Gruppen umfassen, die mit Keten reagieren. Im besonderen liegt das Verhältnis dieser Komponenten zu solchen, die mit Keten reagierende Gruppen enthalten - sofern es sich um zwei Komponenten handelt - bei 0,1:1 bis 1:1. Das für das jeweilige Beispiel entsprechende Verhältnis hängt aber auch von der Anzahl derjenigen funktionellen Gruppen, ab, die mit Keten reagieren, sowie von der Anzahl der verschiedenen Comonomeren im Copolymeren.

Wenn das Comonomere im Falle eines Copolymeren, enthaltend Monomere der allgemeinen Formel I, freie Hydroxylgruppen trägt, kann auf das Bindemittel, das mit Keten reagierende Gruppen enthält, verzichtet werden. Liegt ein solches Copolymeres vor, so ist das Verhältnis von Verbindungen der allgemeinen Formel I zu Comonomeren bei 0,1:1 bis 1:0,1, insbesondere bei 1:1. In diesem Fall ist der Gehalt des Copolymeren 46 Gew.-%, während der Gehalt der Verbindung, deren funktionelle Gruppen mit Keten reagieren können, bei 54 Gew.-%, bezogen auf den Feststoffgehalt des Gemisches, liegen kann.

Enthält das Comonomere keine freien Hydroxylgruppen, so beträgt der Gehalt des Copolymeren, enthaltend Einheiten dieser Comonomeren, 50 Gew.-%, bezogen auf den Feststoffgehalt des strahlungsempfindlichen Gemisches.

In diesen Fällen liegt der Gehalt an Verbindungen, deren funktionellen Gruppen mit Keten reagieren können, bei 10 bis 40 Gew.-%, insbesondere bei 25 Gew.-%, bezogen auf den Feststoffgehalt des strahlungsempfindlichen Gemisches.

Zu den Verbindungen dieser funktionellen Gruppen, die mit Keten abreagieren, zählen solche, die als funktionelle Gruppen -OH,

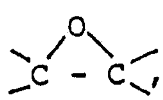

-SH, -NHR, $-NH_2$, $-NR_2$, -COCl, -COOH, $-CONH_2$, -CONHR, $-CSNH_2$, -CSNHR, $-NHNH_2$, $-CONHNH_2$, $-NH-N=CR_2$, -N=C=O und -CHO enthalten. Besonders bevorzugt sind Verbindungen, die als funktionelle Gruppen -OH, -SH, $-NH_2$, -COCl und

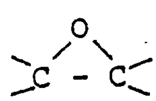

enthalten, insbesondere bevorzugt sind Verbindungen mit -OH-Gruppen und die Bindemittel aus der EP 0 152 819. Die genannten funktionellen Gruppen können sowohl in der Hauptkette als auch in der Seitenkette stehen.

Verbindungen mit den genannten funktionellen Gruppen sind beispielsweise Phenolharze vom Novolak-Typ, wie z. B. Phenol-Formaldehyd-Harze, Kresol-Formaldehyd-Harze, deren Mischkondensate und deren Mischungen, sowie Phenol- und Kresolkondensate mit anderen Aldehyden. Ebenso werden Glycidyl(meth)-acrylate, Polyvinylphenole, Polyvinylalkohole, Hydroxyalkylmethacrylate, d.h. synthetische Verbindungen, die durch Polykondensation oder Polyaddition entstehen, genannt.

Ebenso werden natürliche Polymere verwendet, wie z. B. Cellulose, Stärke, Dextrine und ähnliche sowie deren Ester, und Ether, soweit sie noch freie Hydroxylgruppen tragen. Derivate der Cellulose und Stärke sind z. B. Verbindungen, die hydroxyethyliert oder hydroxypropyliert worden sind.

Neben den funktionellen Gruppen als solche, die die oben beschriebenen Verbindungen aufweisen müssen, um als Bestandteil im erfindungsgemäßen strahlungsempfindlichen Gemisch Verwendung zu finden, muß die genannte Verbindung zudem mit den übrigen Komponenten im Gemisch verträglich sein.

1,2,3-Thiadiazole sind als photochemische Vernetzer aus der Literatur bekannt. Die US-A 3 457 073

beschreibt deren Einsatz in lithographischen Aufzeichnungsmaterialien. Im Gegensatz zu den Polymeren, die durch Polymerisation.der Verbindungen der allgemeinen Formel I entstehen, enthalten die in dieser US-Patentschrift beschriebenen Verbindungen über Carboxylatgruppen an ein vorhandenes Polymeres gebundene 1,2,3-Thiadiazolgruppen, d.h. die Thiadiazolgruppen werden über eine polymeranaloge Umsetzung in das Makromolekül eingebracht. Dieses Verfahren hat aber den Nachteil, daß vollständige Umsetzungen der entsprechenden funktionellen Gruppen kaum durchzuführen sind und eine Abtrennung der nicht chemisch gebundenen Ausgangssubstanzen nicht vollständig möglich ist. Das in der US-A 3 457 073 beschriebene Material ist daher sehr schwer in reproduzierbarer Form zu erhalten.

Es sind aber auch schon Polymere bekannt, die durch Polymerisation von 4- bzw. 5-Alkenyl-thiadiazolen entstehen. M. Pieper und H. Meier beschreiben in Liebigs Ann. Chem. 1986, 1353-1359, auch deren Photoreaktion: Unter Lichteinstrahlung erfolgt eine photochemische Stickstoffabspaltung aus 1,2,3-Thiadiazolen unter Bildung von 1,3-Diradikalen(1), die sich auf verschiedene Weise stabilisieren können. Von besonderem Interesse sind diejenigen Folgereaktionen, die zu Dimerisierungen führen, d.h. eine Reaktionsweise, die die photoohemisch induzierten Vernetzungsreaktionen erklärt.

Photochemisch entstehende Radikale bzw. Produkte:

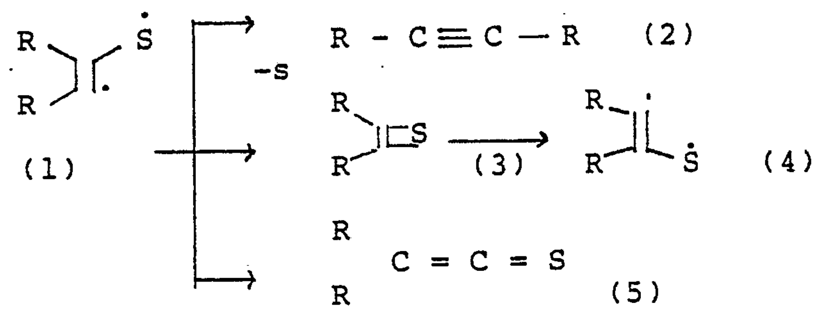

(1) (2) (3) (4) (5)

Dimerisierungsprodukte, Grundlage für die Vernetzung:

(1) + (4)

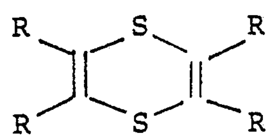

(1) + (2)

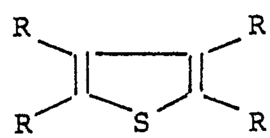

(1) + (5)

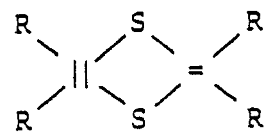

(3) + (5) + S

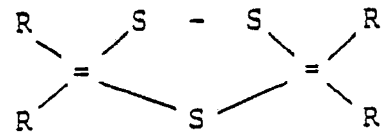

(5) + (5) + 2S

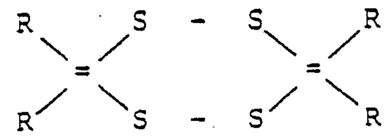

Mit anderen Worten, grundsätzlich sind diese Systeme zur Differenzierung in lithographischen Schichten anwendbar. Es zeigt sich aber, daß die erzielbaren Empfindlichkeiten sogar noch schlechter ausfallen als bei Systemen, die in der US-A 3 457 073 beschrieben sind. Deshalb war es besonders überraschend, daß bei Verwendung dieser Art von 1,2,3-Thiadiazolen und Verbindungen, die funktionelle Gruppen enthalten, die mit Keten reagieren können, eine verbesserte Bilddifferenzierung erreicht werden konnte.

Dem erfindungsgemäßen strahlungsempfindlichen Gemisch können ggf. Farbstoffe, Pigmente, Weichmacher, Netzmittel und Verlaufmittel, aber auch Polyglykole, Celluloseether, z.B. Ethylcellulose, zur Verbesserung spezieller Erfordernisse wie Flexibilität, Haftung und Glanz zugesetzt werden.

Vorzugsweise wird das erfindungsgemäße strahlungsempfindliche Gemisch in Lösemitteln wie Ethylenglykol, Glykolethern (z. B. Glykolmonomethylether, Glykoldimethylether, Glykolmonoethylether oder Propylenglykolmonoalkylethern, insbesondere Propylenglykolmethylether), aliphatischen Estern (z. B. Ethylacetat, Hydroxyethylacetat, Alkoxyethylacetat, n-Butylacetat, Propylenglykolmonoalkyletheracetat, insbesondere Propylenglykolmethyletheracetat oder Amylacetat) Ethern (z. B. Dioxan), Ketonen (z. B. Methylethylketon, Methyl-isobutylketon, Cyclopentanon und Cyclohexanon), Dimethylformamid, Dimethylacetamid, Hexamethylphosphorsäureamid, N-Methyl-pyrrolidon, Butyrolacton, Tetrahydrofuran und in Mischungen derselben gelöst. Besonders bevorzugt werden Glykolether, aliphatische Ester sowie Ketone.

Die mit den Bestandteilen des strahlungsempfindlichen Gemisches entstehenden Lösungen haben in der Regel einen Feststoffgehalt von 5 bis 60 Gew.-%, vorzugsweise bis 50 Gew.-%.

Erfindungsgemäß wird ferner ein strahlungsempfindliches Aufzeichnungsmaterial beansprucht, im wesentlichen bestehend aus einem Schichtträger und dem darauf aufgetragenen strahlungsempfindlichen Gemisch.

Als Schichtträger kommen alle Materialien in Frage, aus denen Kondensatoren, Halbleiter, mehrlagige gedruckte Schaltungen oder integrierte Schaltkreise bestehen bzw. hergestellt werden können. Insbesondere sind Oberflächen aus reinem, thermisch oxydiertem und/oder mit Aluminium beschichtetem Silicium zu nennen, die gegebenfalls auch dotiert sein können, einschließlich aller anderen in der Halbleitertechnologie üblichen Träger bzw. Substrate wie Siliciumnitrid, Galliumarsenid, Indiumphosphid. Weiterhin kommen in Frage die aus der Flüssigkristalldisplay-Herstellung bekannten Substrate wie Glas, Indium-Zinnoxid, ferner Metallplatten und -folien (beispielsweise aus Aluminium, Kupfer, Zink), Bimetall- und Trimetallfolien, aber auch elektrisch nicht leitende Folien, die mit Metallen bedampft sind, z.B. mit Aluminium beschichtete $SiO_2$-Materialien und Papier. Diese Substrate können einer Vorbehandlung durch Erwärmen unterzogen werden, oberflächlich angerauht, angeätzt oder zur Verbesserung erwünschter Eigenschaften, z. B. der Erhöhung der Hydrophilie, mit Chemikalien behandelt sein.

In einer besonderen Ausführungsform kann das strahlungsempfindliche Gemisch zur besseren Haftung in dem Resist oder zwischen dem Resist und dem Träger bzw. Substrat einen Haftvermittler enthalten. Bei Silicium- bzw. Siliciumdioxid-Substraten kommen hierfür Haftvermittler vom Aminosilan-Typ, z.B. 3-Aminopropyl-triethoxysilan oder Hexamethyl-disilazan, in Frage.

Bestrahlt wird das erfindungsgemäße Aufzeichnungsmaterial bildmäßig mit hochenergetischen Strahlungsquellen; bevorzugt ist Elektronen- oder Röntgenstrahlung. Bei Verwendung hinreichend transparenter

Bindemittel ist auch eine bildmäßige Bestrahlung mit kurzwelliger UV-Strahlung (deep UV) möglich.

Die Schichtstärke variiert in Abhängigkeit von ihrem Einsatzgebiet. Sie beträgt etwa 0,1 bis 1000, insbesondere 1 bis 10 µm.

Das Auftragen des strahlungsempfindlichen Gemisches auf den Träger kann durch Aufsprühen, Fließbeschichten, Walzen, Schleuder- und Tauchbeschichten erfolgen. Danach wird das Lösemittel durch Verdampfen entfernt, so daß auf der Oberfläche des Trägers die strahlungsempfindliche Schicht zurückbleibt. Die Entfernung des Lösemittels kann gegebenfalls durch Erhitzen der Schicht auf Temperaturen bis zu 150° C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird. Als Zwischenträger können grundsätzlich alle auch als Trägermaterialien ausgewiesenen Materialien Anwendung finden, soweit sie flexibel sind. Anschließend wird die Schicht bildmäßig bestrahlt. Bevorzugt wird energiereiche Strahlung, wie Röntgen- oder Elektronenstrahlung, verwendet, besonders bevorzugt energiereiche Synchrotronstrahlung mit Dosiswerten von 20 bis 200 $mJ/cm^2$ oder Strahlung eines Elektronenstrahlschreibers. Die eigentliche Differenzierungsreaktion (Vernetzung) kann in einzelnen Fällen bei Raumtemperatur erfolgen. In der Regel ist aber ein Nacherhitzen (post-exposure-bake) günstig, das etwa 1 bis 30 Minuten dauern und vorzugsweise bei Temperaturen von etwa 90 bis 150° C erfolgen kann. In der strahlungsempfindlichen Schicht wird anschließend durch Entwicklung ein Bildmuster freigelegt, indem die Schicht mit einer Entwicklerlösung behandelt wird, die die nicht bestrahlten Bereiche des Materials löst bzw. entfernt.

Als Entwickler werden Lösungen von alkalischen Reagenzien wie Silikaten, Metasilikaten, Hydroxiden, Hydrogen-bzw. Dihydrogenphosphaten, Carbonaten bzw. Hydrogencarbonaten, insbesondere von Alkali- oder Ammoniumionen, aber auch von Ammoniak oder organischen Ammoniumbasen und dergleichen verwendet. Der Gehalt dieser Substanzen in der Entwicklerlösung beträgt im allgemeinen 0,1 bis 15 Gew.-%, vorzugsweise 0,5 bis 5 Gew.-%, bezogen auf das Gewicht der Entwicklerlösung.

Anhand der folgenden Beispiele soll die Herstellung der im erfindungsgemäßen strahlungsempfindlichen Gemisch enthaltenen Copolymeren verdeutlicht werden.

Beispiel 1

a) Copolymerisation von 4-Vinyl-1,2,3-thiadiazol mit 2-Hydroxyethylmethacrylat

2,00 g (17,8 mmol) 4-Vinyl-1,2,3-thiadiazol und 2,32 g (17,8 mmol) 2-Hydroxyethylmethacrylat werden zusammen mit 59 mg Azo-bis-isobutyronitril in 20 ml trockenem Tetrahydrofuran gelöst. Durch die Lösung wird bei 20 °C eine Stunde lang ein trockener Stickstoffstrom geleitet.

Es wird auf 65 °C aufgeheizt und 6 Stunden lang unter Rückfluß gekocht. Nach beendeter Reaktion wird das erhaltene Polymer in 400 ml Hexan ausgefällt, abgesaugt und bei Raumtemperatur im Vakuum getrocknet. Es werden 0,6 g eines leicht gelben, glasartigen Festkörpers gewonnen, der in Dimethylformamid, N-Methylpyrrolidon und THF löslich ist.

Die gelpermeationschromatographische Bestimmung der Molmasse ergab ein $M_w$ von 8000 und ein $M_n$ von 3300 (Polystyrol-Eichung). Aus der Elementaranalyse (50,6 % C, 6,4 % H, 10,0 % N und 11,6 % S) ergibt sich eine Copolymerzusammensetzung von 1 Teil 4-Vinyl-1,2,3-thiadiazol zu 1,4 Teilen 2-Hydroxyethylmethacrylat.

b) Strukturierung des Copolymers mit Elektronenstrahlen

Ein Siliciumwafer (nicht oxidiert) wurde mit Ethanol gereinigt und mit einer 3%igen Lösung des unter a) beschriebenen Copolymeren in Tetrahydrofuran mit Hilfe eines Spin-Coaters beschichtet (5 Sekunden bei 1000 Umdrehungen pro Minute). Es wurde eine Schichtdicke von 0,4 µm erhalten.

Mit einem Raster-Elektronenmikroskop mit Pattern-Generator wurde bei verschiedenen Energiedosen im Bereich von 5 bis 200 $\mu C/cm^2$ ein Streifenmuster in die Schicht geschrieben. Die Muster wurden durch Eintauchen für 10 Sekunden in Tetrahydrofuran entwickelt. Das Ergebnis zeigte, daß schon bei einer Dosis von 20 $\mu C/cm^2$ die Strukturen vollständig gegenüber dem Entwickler resistent waren und eine gute Kantenschärfe (besser als 0,1 µm) besaßen.

Beispiel 2 (Vergleichsbeispiel)

a) Polymerisation von 4-Vinyl-1,2,3-thiadiazol-5-carbonsäure

Das Verfahren entspricht der Vorgehensweise in Beispiel 1a).

b) Strukturierung von Poly-(4-vinyl-1,2,3-thiadiazol)-5-carbonsäure

Ein Siliciumwafer (nicht oxidiert) wurde analog zu Beispiel 1b) gereinigt und mit einer 0,4 µm dicken Schicht aus Poly-(4-vinyl-1,2,3-thiadiazol)-5-carbonsäure beschichtet.

Mit einem Raster-Elektronenmikroskop mit Pattern-Generator wurde bei verschiedenen Energiedosen im Bereich von 10 bis 350 $\mu C/cm^2$ ein Streifenmuster in die Schicht geschrieben. Die Muster wurden durch Eintauchen für 30 Sekunden in Tetrahydrofuran entwickelt. Erst ab einer Dosis von 150 $\mu C/cm^2$ blieben Teile der Strukturen ungelöst im Entwickler; die Differenzierung der Muster war jedoch unzureichend. Durch eine längere Entwicklungszeit (> 1 Minute) wurde letztendlich die bestrahlte Schicht vollständig abgelöst, so daß überhaupt kein Bild erhalten werden konnte.

Beispiel 3

Strukturierung von Poly-(4-vinyl-1,2,3-thiadiazol) im Gemisch mit einem Copolymeren aus Methylmethacrylat und Glycidylmethacrylat (1:1)

Ein Siliciumwafer (nicht oxidiert) wurde analog zu Beispiel 1b) gereinigt und mit einer 0,4 µm dicken Schicht aus 50 Gew.-% Poly-(4-vinyl-1,2,3-thiadiazol) und 50 Gew.-% des Copolymeren aus Methylmethacrylat und Glycidylmethacrylat (1:1) beschichtet.

Mit einem Raster-Elektronenmikroskop mit Pattern-Generator wurde bei verschiedenen Energiedosen im Bereich von 5 bis 200 $\mu C/cm^2$ ein Streifenmuster in die Schicht geschrieben. Die Muster wurden durch Eintauchen für 60 Sekunden in Aceton entwickelt. Erst ab einer Dosis von 5 $\mu C/cm^2$ konnte eine vollständig und gut aufgelöste Struktur mit hoher Kantenschärfe erhalten werden.

Beispiel 4

Strukturierung von Poly-(4-vinyl-1,2,3-thiadiazol) im Gemisch mit einem m-Kresol-Formaldehyd-Novolak

Ein Siliciumwafer (nicht oxidiert) wurde analog zu Beispiel 1b) gereinigt und mit einer 0,4 µm dicken Schicht aus 50 Gew.-% Poly-(4-vinyl-1,2,3-thiadiazol) und 50 Gew.-% eines m-Kresol-Formaldehyd-Novolaks mit einem Erweichungsbereich von 105 bis 120 °C beschichtet.

Mit einem Raster-Elektronenmikroskop mit Pattern-Generator wurde bei verschiedenen Energiedosen im Bereich von 5 bis 200 $\mu C/cm^2$ ein Streifenmuster in die Schicht geschrieben. Die Muster wurden durch Eintauchen für 60 Sekunden in Aceton entwickelt. Schon bei einer Dosis von 10 $\mu C/cm^2$ konnte eine vollständig und gut aufgelöste Struktur mit hoher Kantenschärfe erhalten werden.

## Ansprüche

1. Negativ arbeitendes strahlungsempfindliches Gemisch, enthaltend ein Bindemittel und ein 1,2,3-Thiadiazolgruppen enthaltendes Polymeres, dadurch gekennzeichnet, daß das Bindemittel eine mehrfunktionelle Verbindung darstellt, deren funktionelle Gruppen mit Keten reagieren, und daß das Gemisch als Polymeres eine Verbindung enthält, die durch Polymerisation einer Verbindung der allgemeinen Formel I

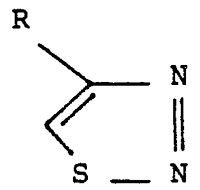

(I)

erhalten wurde, worin R eine polymerisierbare Gruppe bedeutet.

2. Strahlungsempfindliches Gemisch nach Anspruch 1, dadurch gekennzeichnet, daß R Vinyl, 2-Propenyl und Butadienyl bedeutet.

3. Strahlungsempfindliches Gemisch nach den Ansprüchen 1 oder 2, dadurch gekennzeichnet, daß die mit Keten abreagierende Verbindung ein mehrfunktioneller Alkohol ist.

4. Strahlungsempfindliches Gemisch nach einem oder mehreren der Ansprüche 1 bis 3, dadurch gekennzeichnet, daß das Polymere ein Copolymeres ist.

5. Strahlungsempfindliches Gemisch nach Anspruch 4, dadurch gekennzeichnet, daß als Comonomeres Verbindungen eingesetzt werden, die funktionelle Gruppen enthalten, die mit Keten reagieren können.

6. Negativ arbeitendes strahlungsempfindliches Gemisch mit einem 1,2,3-Thiadiazolgruppen enthaltenden Polymeren, dadurch gekennzeichnet, daß als Polymeres eine Verbindung eingesetzt wird, die durch Polymerisation einer Verbindung der allgemeinen Formel I

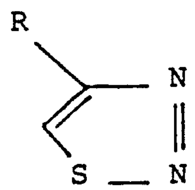

(I)

worin R eine polymerisierbare Gruppe bedeutet, mit einem Comonomeren erhalten wurde; diese Verbindung enthält funktionelle Gruppen, die mit Keten reagieren können.

7. Strahlungsempfindliches Gemisch nach Anspruch 6, dadurch gekennzeichnet, daß als Comonomeres ein alkoholische Hydroxylgruppen enthaltendes Monomeres eingesetzt wird.

8. Negativ arbeitendes strahlungsempfindliches Aufzeichnungsmaterial, im wesentlichen bestehend aus einem Träger und einer strahlungsempfindlichen Schicht, dadurch gekennzeichnet, daß ein strahlungsempfindliches Gemisch nach einem der Ansprüche 1 bis 7 verwendet wird.